# EUROPÄISCHE PATENTANMELDUNG

(11) **EP 0 737 028 A1**
(43) Veröffentlichungstag der Anmeldung: **09.10.1996**
(21) Anmeldenummer: 95119111.3
(22) Anmeldetag: 05.12.1995
(51) Int. Cl.: H05K 7/14

(54) **Haltevorrichtung für kartenförmige Trägerelemente**

(30) Priorität: 07.04.1995 DE 29506013 U
(71) Anmelder: STOCKO Metallwarenfabriken Henkels und Sohn GmbH & Co, 42327 Wuppertal (DE)
(72) Erfinder: Klatt, Dieter, D-42489 Wülfrath (DE)
(74) Vertreter: Stenger, Watzke & Ring Patentanwälte

(57) **Zusammenfassung**

Die Erfindung betrifft eine Haltevorrichtung für kartenförmige, in mit Einschubschlitzen versehenen Kontaktiereinheiten einschiebbare Trägerelemente elektronischer Baugruppen, wobei die Kontaktiereinheit wenigstens einen in den Einschubkanal hineinragenden und aus diesem herausbewegbaren Vorsprung aufweist, der in eine im Trägerelement ausgebildete Ausnehmung einrastet, wenn das Trägerelement in einer Betriebsposition in der Kontaktiereinheit positioniert ist.

## Beschreibung

Die Erfindung betrifft eine Haltevorrichtung für kartenförmige, in mit Einschubschlitzen versehenen Kontaktiereinheiten einschiebbare Trägerelemente elektronischer Baugruppen.

Insbesondere im Bereich der Computertechnologie werden elektronische Baugruppen vorzugsweise auf kartenförmigen Trägerelementen angeordnet. Diese Trägerelemente weisen Kontaktbereiche auf und sind in Kontaktiereinheiten einschiebbar, wo sie elektrisch kontaktiert und in den Datenkreislauf integriert werden. Es sind kartenförmige Trägerelemente nach der sogenannten PCMCIA-Norm bekannt, wobei es sich um Karten handelt, die einen normgemäßes matrixartiges Anschlußkontaktfeld aufweisen und unterschiedlichste IC-Schaltkreise aufnehmen können. Derartige Karten können Speichererweiterungskarten, Laufwerkskarten, Modemkarten und dergleichen sein. Sie lassen sich in Kontaktiereinheiten mit einer entsprechenden Stiftmatrix kontaktieren, wozu sie in den Einschubschlitz beispielsweise eines Computers eingeschoben werden. Auch sind sogenannte Chip-Karten bekannt, wie sie derzeit beispielsweise als Telefonkarten und dergleichen Verwendung finden. Diese weisen flächig angeordnete Kontaktfelder für die Kontaktierung eines Chips auf und werden ebenfalls in insbesondere als Leseeinheiten ausgebildete Kontaktiereinheiten eingeschoben. In neuester Zeit ist auch die Kombination bekannter Kartensysteme bekannt, wobei beispielsweise gleichzeitig eine PCMCIA- und eine Chip-Karte in eine entsprechende Kontaktiereinheit eingeschoben werden.

Die vorbekannten Systeme sind so ausgebildet, daß keine besonderen Halte- bzw. Rasteinheiten vorgesehen sind. Bei Chip-Karten werden diese insbesondere über Flächenpressungen gehalten, wozu Gummi- oder Silikonklemmer verwendet werden. Bei PC-Karten mit entsprechenden Anschlußfeldern werden Haltekräfte nur über die Anschlußkontakte bereitgestellt. Insbesondere bei mobilen oder infolge des Einsatzortes beweglichen oder schwingenden Kontaktiereinheiten kann eine sichere Kontaktierposition nicht gewährleistet werden.

Ausgehend von diesem Stand der Technik liegt der vorliegenden Erfindung die **Aufgabe** zugrunde, eine Haltevorrichtung für kartenförmige Trägerelemente bereitzustellen, durch welche eine sichere Kontaktierung in der Betriebsposition gewährleistet ist.

Zur technischen **Lösung** dieser Aufgabe wird eine Haltevorrichtung für kartenförmige, in mit Einschubschlitzen versehenen Kontaktiereinheiten einschiebbare Trägerelemente elektronischer Baugruppen vorgeschlagen, wobei die Kontaktiereinheit wenigstens einen in den Einschubkanal hineinragenden und aus diesem herausbewegbaren Vorsprung aufweist ,der in eine im Trägerelement ausgebildete Ausnehmung einrastet, wenn das Trägerelement in einer Betriebsposition in der Kontaktiereinheit positioniert ist.

Durch die erfindungsgemäße Lösung wird eine Haltevorrichtung vorgeschlagen, mit welcher moderne kartenförmige Trägerelemente elektronischer Baugruppen sicher in den Betriebspositionen in den Kontaktiereinheiten gehalten werden können. In den Trägerelementen ausgebildete Ausnehmungen können nockenartige Elemente aufnehmen, die in den Kontaktiereinheiten angeordnet sind. Derartige erfindungsgemäße Haltevorrichtungen sind normierbar und können für unterschiedlichste Systeme verwendet werden. Die Betriebssicherheit der modernen Datenverarbeitungssysteme wird damit erheblich verbessert. Durch die Vorsprünge, beispielsweise in Form von Nockenelementen, die gemäß einem vorteilhaften Vorschlag der Erfindung federbelastet sein können, kann ein Herauswandern einer PC-Karte oder einer Chip-Karte aus der Betriebsposition verhindert werden.

Gemäß einem vorteilhaften Vorschlag der Erfindung werden die Vorsprünge durch Federelemente gebildet. Einfache gebogene streifenförmige Elemente können in den Einschubkanal einer Kontaktiereinheit hineinragen und durch die eingeschobene Chip-Karte zur Seite gedrängt werden, bis sie in eine korrespondierende Ausnehmung in der Chip-Karte einrasten. Gemäß einem vorteilhaften Vorschlag der Erfindung ist ein Vorsprung wenigstens an einer der Schlitzschmalseiten angeordnet. Ein derartiger Vorsprung kann leicht in eine einfache, nutartige Ausnehmung im Kartenrandbereich einrasten. Derartige erfindungsgemäße Systeme lassen sich auch nachrüsten, so daß auch herkömmliche Kontaktiereinheiten mit entsprechenden Haltevorrichtungen bestückt werden können.

Gemäß einem vorteilhaften Vorschlag der Erfindung sind die Federelemente aus Kunststoff gebildet. Alternativ kann beispielsweise Metall verwendet werden.

Gemäß einem vorteilhaften Vorschlag der Erfindung werden Mehrfachfederelemente verwendet. Diese haben den Vorteil, als einfache Bauteile für unterschiedlichste Kartensysteme einsetzbar zu sein.

Gemäß einem besonders vorteilhaften Vorschlag der Erfindung sind die Federelemente als elektrische Kontaktelemente ausgebildet. Durch diese erfindungsgemäße Ausgestaltung können neben reinen mechanischen Haltefunktionen auch elektrische bzw. elektronische Aufgaben von den Federelementen übernommen werden. So können die Federelemente gemäß einem besonders vorteilhaften Vorschlag der Erfindung in einer Positionskodierung angeordnet werden. Wenigstens zwei Federelemente können so angeordnet sein, daß sie nur mit Karten kombiniert werden können, die ihrerseits an den vorgegebenen Positionen Ausnehmungen haben. Sind die Federelemente als elektrische Kontaktelemente ausgebildet, kann durch diese erfindungsgemäße Ausgestaltung verhindert werden, daß Karten mit der Kontaktiereinheit kombiniert werden, die nicht die entsprechende Positionierung der Ausnehmungen aufweisen.

In erfindungsgemäßer Weise können die Ausnehmungen als Nuten am Kartenrand ausgebildet sein oder als Senken im Kartenflächenbereich.

Die erfindungsgemäße Haltevorrichtung läßt sich in einfachster Weise ausgestalten und ist vielseitig und wirkungsvoll zur Erhöhung der Betriebssicherheit moderner Speicher- und Datenverarbeitungssysteme einsetzbar.

Weitere Vorteile und Merkmale der Erfindung ergeben sich aus der folgenden Beschreibung anhand der Figuren. Dabei zeigen:
- Figur 1: eine schematische Draufsicht auf ein Ausführungsbeispiel einer Haltevorrichtung;
- Figur 2: eine schematische Seitenansicht eines Typs einer Trägerkarte;
- Figur 3: eine schematische Seitenansicht eines anderen Typs einer Trägerkarte;
- Figur 4: eine Draufsicht einer schematischen Darstellung einer in eine Kontaktiereinheit eingeschobenen Trägerkarte;
- Figur 5: eine schematische Seitenansicht eines Doppelkartensystems und
- Figur 6: eine schematische perspektivische Ansicht eines Systems gemäß Figur 5.

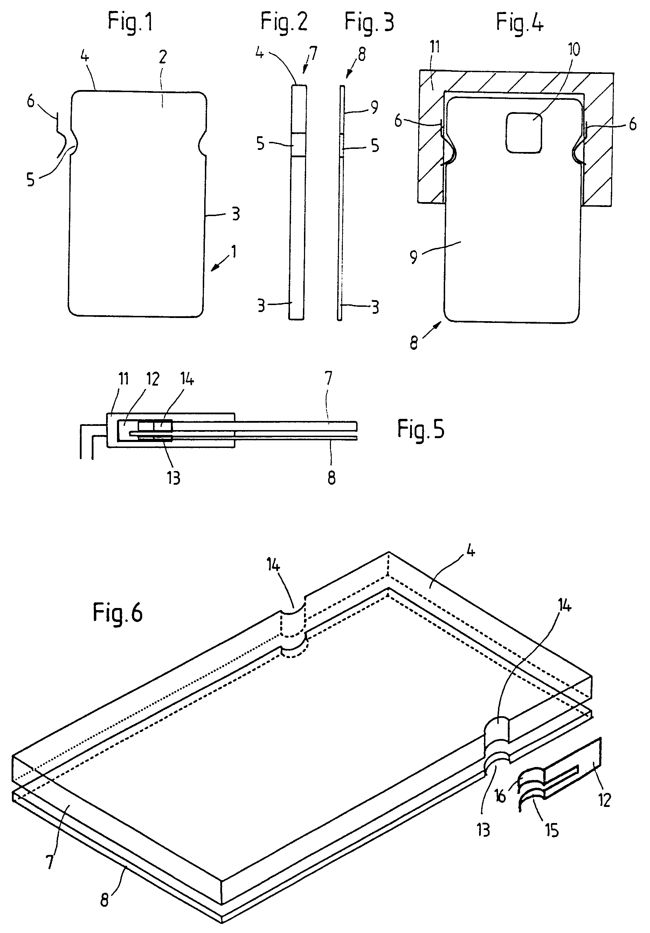

Figur 1 zeigt eine Trägerkarte 1, deren obere Fläche 2 gezeigt ist. Die Karte kann beispielsweise am hinteren Rand 4 eine Kontaktmatrix aufweisen. Im Bereich der seitlichen Ränder 3 sind Buchten 5 angeordnet, in die beispielsweise ein Federelement 6 einrasten kann.

Unterschiedliche Typen von Trägerkarten sind in den Figuren 2 und 3 gezeigt. Figur 2 zeigt eine sogenannte PC-Karte 7, bei welcher am hinteren Rand 4 eine normgemäße Anschlußmatrix ausgebildet ist. Diese unter die sogenannte PCMCIA-Norm fallende Karte weist im gezeigten Ausführungsbeispiel an einem der Seitenränder 3 eine Bucht 5 zum Einrasten eines Federelementes auf. In Figur 3 ist eine sogenannte Chip-Karte in Seitenansicht gezeigt, die auf der Chip-Oberfläche 9 einen Chip aufweist, der von Kontaktflächen umgeben ist. Diese Chip-Karte 8 weist ebenfalls im Bereich eines Seitenrandes 3 eine Bucht 5 auf.

Die Kontaktierung ist beispielsweise in Figur 4 gezeigt. Eine Chip-Karte 8 ist in eine Kontaktiereinheit 11 in einen Einschubschlitz eingeschoben. Federelemente 6 sind an beiden Seitenrändern in dort angeordnete Buchten eingesetzt. Auf der Chipoberfläche 9 ist ein Chip 10 angeordnet, welcher von Kontaktfeldern umgeben ist und in der Kontaktiereinheit 11 mit entsprechenden Kontakten in Berührung kommt.

Figur 5 zeigt ein System, bei welchem sowohl eine PC-Karte 7 als auch eine Chip-Karte 8 in den Einschubschlitz einer Kontaktiereinheit 11 eingeschoben werden. Eine Doppelfeder 12 weist zwei Arme auf, die federnd in die Buchten 13 der Chip-Karte 8 bzw. 14 der PC-Karte 7 einrasten. Perspektivisch ist dieses System in Figur 6 angedeutet, wo das Doppelfederelement 12 mit den beiden Federn 15 und 16 gezeigt ist, die in die entsprechenden Buchten 13 bzw. 14 der PC-Karte 7 bzw. Chip-Karte 8 einrasten.

Nur beispielsweise sind in den gezeigten Ausführungsbeispielen die Haltevorrichtungen an einer Seite der Karten gezeigt. Die Karten können auch im Bereich der Flächen 2 Ausnehmungen aufweisen, in welche Federelemente einrasten können. Auch sind Kombinationen von Federelementen möglich, so daß sich Kodierungsmöglichkeiten ergeben. Schließlich kann auch eine PCMCIA-Karte zur Aufnahme einer Chip-Karte mit einem Einschubkanal versehen sein, in welchem Federelemente angeordnet sind, die mit Ausnehmungen in der Chip-Karte zusammenwirken.

### Bezugszeichenliste:

- 1: Trägerkante
- 2: Fläche
- 3: Rand
- 4: hinterer Rand
- 5: Bucht
- 6: Federelement
- 7: PC-Karte
- 8: Chip-Karte
- 9: Chipoberfläche
- 10: Chip
- 11: Kontaktiereinheit
- 12: Doppelfederelement
- 13: Bucht
- 14: Bucht
- 15: Feder
- 16: Feder

## Patentansprüche

1. Haltevorrichtung für kartenförmige, in mit Einschubschlitzen versehenen Kontaktiereinheiten einschiebbare Trägerelemente elektronischer Baugruppen, dadurch gekennzeichnet, daß die Kontaktiereinheit wenigstens einen in den Einschubkanal hineinragenden und aus diesem herausbewegbaren Vorsprung aufweist, der in eine im Trägerelement ausgebildete Ausnehmung einrastet, wenn das Trägerelement in einer Betriebsposition in der Kontaktiereinheit positioniert ist.

2. Haltevorrichtung nach Anspruch 1, dadurch gekennzeichnet, daß der wenigstens eine Vorsprung federbelastet ist.

3. Haltevorrichtung nach einem der vorhergehenden Ansprüche, dadurch gekennzeichnet, daß der wenigstens eine Vorsprung ein Federelement ist.

4. Haltevorrichtung nach einem der vorhergehenden Ansprüche, dadurch gekennzeichnet, daß der wenigstens eine Vorsprung an einer der Schlitzschmalseiten angeordnet ist.

5. Haltevorrichtung nach einem der vorhergehenden Ansprüche, dadurch gekennzeichnet, daß mehrere Vorsprünge durch ein Mehrfachfederelement bereitgestellt sind.

6. Haltevorrichtung nach einem der vorhergehenden Ansprüche, dadurch gekennzeichnet, daß die Federelemente aus Kunststoff gebildet sind.

7. Haltevorrichtung nach einem der vorhergehenden Ansprüche, dadurch gekennzeichnet, daß die Vorsprünge als elektrische Kontaktelemente ausgebildet sind.

8. Haltevorrichtung nach einem der vorhergehenden Ansprüche, dadurch gekennzeichnet, daß eine Mehrzahl von Vorsprüngen eine Positionskodierung bilden.

9. Haltevorrichtung nach einem der vorhergehenden Ansprüche, dadurch gekennzeichnet, daß die im Trägerelement ausgebildete wenigstens eine Ausnehmung am Kartenrand angeordnet ist.

10. Haltevorrichtung nach einem der vorhergehenden Ansprüche, dadurch gekennzeichnet, daß das Trägerelement eine Senke im Kartenflächenbereich aufweist.
